Europäisches Patentamt

European Patent Office

Office européen des brevets

(19)

(11) **EP 0 954 025 A1**

(12) **EUROPEAN PATENT APPLICATION**

(43) Date of publication:
**03.11.1999 Bulletin 1999/44**

(51) Int Cl.$^6$: **H01L 23/495**, H01L 21/58

(21) Application number: **99303045.1**

(22) Date of filing: **20.04.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **28.04.1998 US 67499**

(71) Applicant: **LUCENT TECHNOLOGIES INC.**
**Murray Hill, New Jersey 07974-0636 (US)**

(72) Inventors:
• **Abys, Joseph Anthony**
**Warren, New Jersey 07059 (US)**
• **Fan, Chonglun**
**Basking Ridge, New Jersey 07920 (US)**

(74) Representative:
**Johnston, Kenneth Graham et al**
**Lucent Technologies (UK) Ltd,**
**5 Mornington Road**
**Woodford Green Essex, IG8 OTU (GB)**

(54) **Process for controlling resin bleeding in integrated circuit packaging**

(57)     A method for controlling resin bleeding on integrated circuit packages (125) is disclosed. Resin bleeding is controlled by lowering the surface energy of an IC substrate (110) to less than or about equal to the surface energy of an adhesive (130) which attaches IC units thereto. The IC substrate is treated with a material (150) that lowers its surface energy. The material layer forms a less wettable surface on the IC substrate which inhibits resin bleeding when the adhesive applied thereto is hardened. The material layer is formed from a solution of a polymer in a solvent. Suitable polymers include polyfluorinated hydrocarbon compounds.

FIG. 4

EP 0 954 025 A1

## Description

### 1. Field of the Invention

The present invention relates generally to integrated circuit packages, and more particularly, to resin bleeding during integrated circuit package assembly.

### 2. Description of the Related Art

Integrated circuit (IC) packages are protective enclosures within which are typically sealed an integrated circuit (IC) unit and a leadframe. The IC unit is attached to the leadframe. The leadframe electrically interconnects the IC unit to circuitry located outside of the IC package. Leadframes are typically formed from a conductive material such as copper.

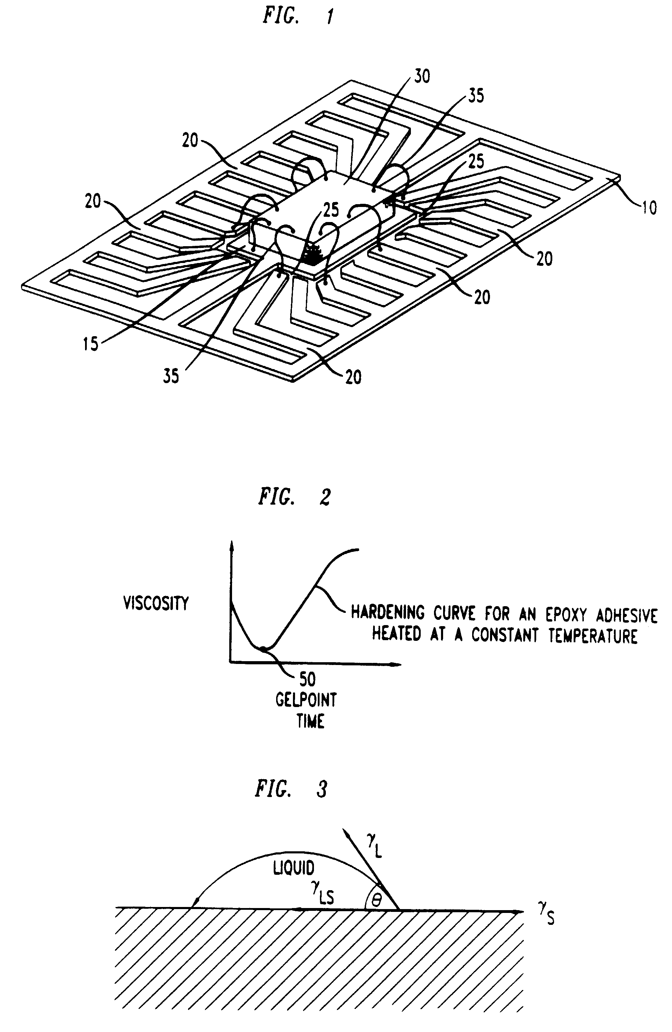

A leadframe 10 useful for integrated circuit packages is shown in FIG. 1. The leadframe 10 includes a mounting area 15 and a plurality of lead members 20. The lead members 20 extend away from locations 25 adjacent to the mounting area 15. The IC unit 30 is attached on the mounting area 15 of leadframe 10. Wire bonds 35 extending between the IC unit 30 and the lead members 20 electrically connect the IC 35 unit with the lead members 20. Examples of IC units include integrated circuit chips and hybrid integrated circuit modules. Hybrid integrated circuit modules typically include one or more IC chips as well as other electronic components mounted on a plastic or ceramic carrier.

Many IC units are attached to leadframes with an adhesive. Adhesives useful for attaching IC units to lead frames typically combine metal particles (e.g., silver, gold) with a resin such as an epoxy. IC units are attached to leadframes by applying the adhesive on the leadframe mounting area. Thereafter, IC units are placed on the adhesive and the adhesive is hardened (cured). Epoxy based adhesives are typically hardened with heat.

The graph of FIG. 2 depicts a typical hardening curve for an epoxy based adhesive, heated at a constant temperature. On the graph of FIG. 2, the viscosity of the epoxy based adhesive is plotted as a function of time. This graph illustrates that during the initial stages of the hardening step, there is a marked drop in the viscosity of the epoxy based adhesive. The viscosity falls to a minimum when the epoxy based adhesive reaches the gel point 50. The term gel point as used in this disclosure describes the point on the heating curve at which the viscosity of the adhesive starts to increase with time, hardening the adhesive. The time needed for reaching the gel point depends on the particular adhesive used and the temperature at which it is heated.

One problem with epoxy based adhesives is "resin bleeding". The term resin bleeding as used in this disclosure refers to the separation of the resin from the adhesive. Resin bleeding typically occurs when the adhesive is heated, during the time before it reaches the gel point. Heating causes portions of the resin and metal particles to flow away from the IC mounting area. Resin and metal particles that flow over the mounting area onto lead members potentially contaminate both the IC mounting area and the lead members. For example, resin flowing over the IC mounting area onto the lead members forms a barrier layer that affects the adhesion strength of wire bonds made thereto.

U. S. Patent 4,143,456 issued March 13, 1979 discusses the use of a repellent material formed around the outer perimeter of a semiconductor device. The repellent material is made of silicone and has a thickness of about 50 µm. The thickness of the repellent material forms a barrier which prevents a resin encapsulant applied on the semiconductor device from spreading thereebeyond. This barrier approach, however, has disadvantages. For example, the barrier of repellent material must be formed around each area within which the resin encapsulant is to be confined. Formation of the barrier around each area requires additional processing steps to pattern the repellent material which is costly for substrates requiring the attachment of a high density of semiconductor devices, as is often the case in electronic device manufacture.

U. S. Patent 5,646,241 issued July 8, 1997 discusses adhesive formulations containing small amounts (up to 10 weight percent) of a bleed control agent. The bleed control agent shortens the time needed for the adhesive formulations to reach their gel points. Adhesive formulations that reach their gel points faster have a smaller time window before hardening starts, resulting in less resin bleeding. Although bleed control agents reduce resin bleeding, adhesive formulations that contain bleed control agents are difficult to synthesize. For example, many adhesive formulations are pastes. It is time consuming and costly to uniformly distribute small amounts of the bleed control agents throughout pastes.

### Summary of the Invention

The present invention is directed to a method for controlling resin bleeding in IC packaging. The resin bleeding is controlled by reducing the surface energy of an IC substrate (e.g., leadframe) to a surface energy that is less than or about equal to the surface energy of an adhesive applied thereon. The term surface energy as used in this disclosure refers to an energy needed to form a boundary region between two adjacent phases.

In the present invention, the IC substrate is treated with a material that lowers its surface energy. Such materials make the surface of the IC substrate less wettable. A less wettable surface on the IC substrate is desirable because it inhibits the flow of resin thereover, when the adhesive is hardened.

The material is formed from a solution of a polymer in a solvent. The surface energy of a layer of the material formed from the polymer solution depends on the particular polymer used as well as the concentration of the polymer in the solvent. Polymers useful for forming material layers having surface energies less than or about equal to the surface energies of many adhesives (less than about 100 erg/cm$^2$) are polyfluorinated hydrocarbon compounds. Examples of suitable polyfluorinated hydrocarbon compounds include fluorinated alkyl quaternary ammonium iodides and potassium fluorinated alkyl carboxylates. Suitable solvents include water and alcohols such as isopropyl alcohol, ethanol, and 2-butoxyethanol.

A layer of the material is formed on the IC substrate by applying the solution on the IC substrate and then removing the solvent. The solution is applied on the substrate using any suitable method including spraying and dipping. After the solution is applied on the substrate, the solvent is removed by heating and/or drying the substrate.

The lower surface energy layer preferably has a thickness less than about 0.5 μm. Layers less than about 0.5 μm thick do not degrade the bonding strength between the adhesive and the substrate.

After the lower surface energy layer is formed on the substrate, an adhesive is applied on at least a portion of the material layer. The adhesive combines a resin and metal particles. Suitable adhesives include alkyl glycidyl ethers and epoxypropoxy butanes.

An IC device such as a semiconductor device is placed on the adhesive. Thereafter, the adhesive is hardened. The adhesive is hardened by heating it at a constant temperature, to achieve a desired viscosity. The adhesive is heated using conventional methods such as placing the substrate in an oven, or on a hot plate.

In an alternate embodiment of the present method, the material layer which controls resin bleeding in IC packages is formed on the surface of the IC substrate after the adhesive is applied thereon.

Other objects or features of the present invention will become apparent from the following detailed description considered in conjunction with the accompanying drawings. It is to be understood, however, that the drawings are designed solely for purposes of illustration and do not serve to limit the invention, for which reference should be made to the appended claims.

## Brief Description of the Drawings

FIG. 1 shows a leadframe typically used for packaging integrated circuit devices;
FIG. 2 depicts a typical hardening curve for an epoxy based adhesive, heated at a constant temperature;
FIG. 3 illustrates the wetting ability of a solid surface by a liquid;
FIG. 4 is a cross-sectional view of an IC substrate including the material layer of the present invention thereon; and
FIG. 5 shows a plot of the surface energy of a material layer as a function of the concentration of fluorinated alkyl quaternary ammonium iodide in a polymer solution.

## Detailed Description

The present invention is directed to a method which controls resin bleeding in IC packages. Resin bleeding is controlled by lowering the surface energy of an IC substrate to less than or about equal to the surface energy of an adhesive used for attaching an IC unit thereto. Lowering the surface energy of the IC substrate makes the surface of the IC substrate less wettable. A less wettable surface on the IC substrate is desirable because it inhibits the flow of resin thereover, as the adhesive hardens.

The wetting ability of a solid surface by a liquid is described by

$$\gamma_S = \gamma_L \cos\theta + \gamma_{LS} \qquad (1)$$

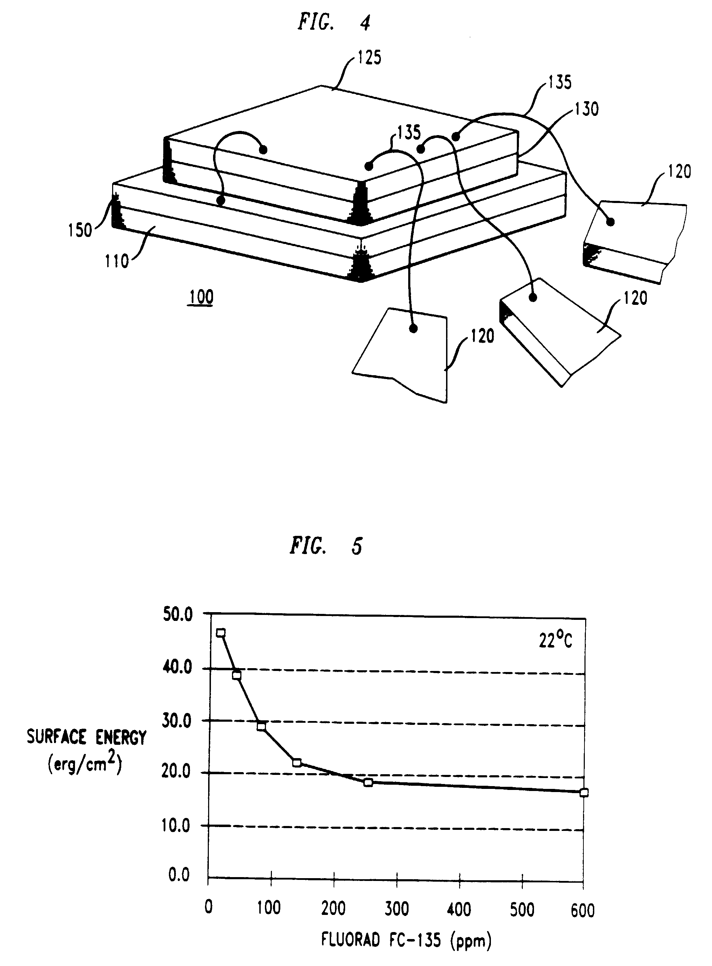

As shown in FIG. 3, equation (1) relates the surface energy of a solid ($\gamma_S$) with the surface energy of a liquid ($\gamma_L$) placed thereon, the surface energy of the liquid-solid interface ($\gamma_{LS}$), and the contact angle ($\cos\theta$) between the liquid and the solid surface. Based on equation (1), complete wetting of the solid surface occurs when $\theta$ is zero degrees. $\theta$ approaches zero degrees when the surface energy of the solid is larger than the surface energy of the liquid.

Typically, IC substrates have surface energies at least one order of magnitude greater than the surface energies of adhesives used for attaching IC units thereto. For example, a gold plated leadframe has a surface energy of about 1200 erg/cm$^2$ at room temperature, while soft organic materials such as adhesives have surface energies less than about 100 erg/cm$^2$. Because the surface energy of the IC substrate is larger than the surface energy of any adhesive placed thereon, resin that separates from the adhesive during the hardening step spreads over the substrate surface.

FIG. 4 shows a cross-sectional view of a leadframe 100 useful as an IC substrate. Leadframe 100 has an IC mounting area 110 with a plurality of separate lead members 120 extending away from locations adjacent to the mounting area 110. IC substrates such as leadframe 100 are formed of a conductive material such as copper. Leadframes made of copper are typically plated with one or more layers of metal. The metal provides a barrier to the formation of corrosive products of copper (e.g., copper oxides and copper sulfides) on the surface of the leadframe. Examples of suitable metal layers include nickel and palladium, with or without a gold layer thereover.

An IC unit **125** is attached to mounting area **110** with an adhesive **130**. Wire bonds **135** formed between the IC unit **125** and the lead members **120** electrically connect the IC unit **125** with leadframe **100**.

In one embodiment of the present invention, a material layer **150** is formed on the IC substrate such as leadframe **100**, as shown in FIG. 4. The material layer **150** is formed over all or part of the leadframe **100**.

The material layer is formed from a solution of a polymer in a solvent. The surface energy of material layers formed from the polymer solution depend on the particular polymer used as well as the concentration of the polymer in the solvent. Polymers useful for forming material layers having surface energies less than or about equal to the surface energies of many adhesives (less than about 100 erg/cm$^2$) are polyfluorinated hydrocarbon compounds. Suitable polyfluorinated hydrocarbon compounds include fluorinated alkyl quaternary ammonium iodides (e.g., Fluorad FC-135 available from 3M Company) and potassium fluorinated alkyl carboxylates (e.g., Fluorad FC-129 available from 3M Company). Suitable solvents include water and alcohols such as isopropyl alcohol, ethanol, and 2-butoxyethanol.

The graph of FIG. 5 plots the surface energy of material layers as a function of the concentration of fluorinated alkyl quaternary ammonium iodide in the polymer solution. The fluorinated alkyl quaternary ammonium iodide solutions are dilutions of Fluorad FC-135 in water. The graph of FIG. 5 illustrates that solutions containing about 10 - 600 ppm (parts per million) Fluorad FC-135 in water form layers with surface energies ranging from about 17 erg/cm$^2$ to about 46 erg/cm$^2$. Such a range of surface energies is compatible with adhesives having surface energies of at least about 50 erg/cm$^2$.

The material layer is formed by applying the solution on the IC substrate and then removing the solvent. The solution is applied on the substrate using any suitable method including spraying and dipping. After the solution is applied on the substrate, the solvent is removed by heating and/or drying the substrate.

The lower surface energy layer preferably has a thickness less than about 0.5 µm. Layers less than about 0.5 µm thick do not substantially degrade the bonding strength between the adhesive and the substrate. For example, leadframes with the material layer of the present invention formed thereon require average forces of about 880 grams to shear an IC unit attached thereto. Leadframes without the material layer of the present invention formed thereon require average forces of about 840 grams to shear the IC unit. Additionally, materials layers with such thicknesses do not affect the electrical conductivity of the adhesive bonds made thereto.

After the lower surface energy layer is formed on the substrate, an adhesive is applied on at least a portion of the material layer. The adhesive combines a resin such as an epoxy with metal particles. Suitable adhesives include polyether aliphatic polyurethane (e.g.,

P-3429 and Pn03 available from K. J. Quinn & Company, Malden, MA) as well as alkyl glycidyl ethers and epoxypropoxy butanes (e.g. Ablebond 826-1 available from Ablestik Company).

An IC device such as a semiconductor device is placed on the adhesive. Thereafter, the adhesive is hardened. The adhesive is hardened by heating it for a period of time at a constant temperature, until a desired viscosity is achieved. The adhesive is heated using conventional methods such as placing the substrate in an oven, or on a hot plate.

In an alternate embodiment of the present method, the adhesive is applied on the IC substrate before the material layer is formed thereon. For such an embodiment, the adhesive is applied on the IC substrate. The material layer is formed on at least a portion of the substrate including the adhesive by applying the solution containing the polymer in the solvent on the IC substrate. Thereafter, the solvent is removed by heating and/or drying the IC substrate.

Forming the material layer which controls resin bleeding on the adhesive does not degrade the bonding strength between the adhesive and an IC unit attached thereover. Additionally, materials layers formed over the adhesive do not substantially affect the electrical conductivity of the IC units attached thereon.

The following examples are provided to illustrate a specific embodiment of the present invention.

## Example 1

A drop of Ablebond 826-1 silver filled epoxy was applied on a Ni/Pd/Au plated leadframe. The drop of Ablebond 826-1 had a radius of about 0.020 inches. Ablebond 826-1 is commercially available from Ablestik Company, Los Angeles, California. The Ni/Pd/Au plated leadframe was obtained from Precision Plating Company, Chicago, Illinois.

The leadframe with the Ablebond 826-1 thereon was heated in an Isotemp 630F oven at a temperature between about 150 - 155 °C, for about 1 hour. The Isotemp 630F oven is commercially available from Fisher Scientific Company. After heating, the drop of Ablebond 826-1 had a radius of about 0.045 inches, which is an increase of about 125 %.

## Example 2

A Ni/Pd/Au plated leadframe was dipped in a solution containing 20 ml of Fluorad FC-135 in 980 ml of deionized water for about 10 seconds. After dipping, the Ni/Pd/Au plated leadframe was dried in air forming a layer containing Fluorad FC-135 thereon. The Ni/Pd/Au plated leadframe was obtained from Precision Plating Company. The Fluorad FC-135 was obtained from the 3M Company.

A drop of Ablebond 826-1 was applied on the layer containing Fluorad FC-135. The drop of Ablebond 826-1 had a radius of 0.020 inches. The Ni/Pd/Au plated leadframe was heated according to the conditions described in Example 1. After heating, the drop of Ablebond 826-1 had a radius of about 0.022 inches, which is an increase of about 10 %.

**Example 3**

A Ni/Pd/Au plated leadframe was dipped in a solution containing 20 ml of Fluorad FC-129 in 980 ml of deionized water for about 10 seconds. After dipping, the Ni/Pd/Au plated leadframe was dried in air forming a layer containing Fluorad FC-129 thereon. The Fluorad FC-129 was obtained from the 3M Company.
A drop of Ablebond 826-1 was applied on the layer containing Fluorad FC-129. The drop of Ablebond 826-1 had a radius of 0.020 inches. The Ni/Pd/Au plated leadframe was heated according to the conditions described in Example 1. After heating, the drop of Ablebond 826-1 had a radius of about 0.022 inches, which is an increase of about 10 %.

**Claims**

1. A method for making an integrated circuit package comprising the steps of:

   providing a substrate wherein the substrate has a first surface energy;
   lowering the surface energy of the substrate by forming a layer of a material over at least a portion of the substrate, wherein the material layer has a second surface energy that is lower than the first surface energy;
   applying an adhesive on the material layer;
   applying an integrated circuit device on the adhesive; and
   heating the adhesive to harden the adhesive and attach the semiconductor device on the substrate.

2. A method for making an integrated circuit package comprising the steps of:

   providing a substrate wherein the substrate has a first surface energy;
   applying an adhesive on the substrate;
   forming a layer of material over at least a portion of the substrate, wherein the material layer has a second surface energy that is lower than the first surface energy;
   applying an integrated circuit device on the adhesive; and
   heating the adhesive to harden the adhesive and attach the semiconductor device on the substrate.

3. An integrated circuit package comprising:

   a substrate wherein the substrate has a first surface energy;
   a material layer formed on at least a portion of the substrate, wherein the material layer has a second surface energy that is lower than the first surface energy;
   an adhesive formed on the substrate; and
   an integrated circuit device affixed to the adhesive.

4. The method of claim 1, or 2 or the package of claim 3, wherein the material layer has a thickness less than about 0.5 µm.

5. The method of claim 1, or 2 wherein the adhesive applied on the substrate has a radius which expands less than about 25% during the heating step.

6. The method of claim 1, or 2 or the package of claim 3, wherein the layer of material is formed from a solution of a polymer in a solvent, the polymer being for example a polyfluorinated hydrocarbon compound, such as selected from fluorinated alkyl quaternary ammonium iodide and a potassium fluorinated alkyl carboxylate, and/or the solvent being for example selected from water and an alcohol, the latter for example being selected from isopropyl alcohol, ethanol, and 2-butoxyethanol.

7. The method or the package of claim 6, wherein the concentration of the polyfluorinated hydrocarbon compound in the solution is within the range of about 10-600 ppm (parts per million).

8. The method of claim 1, or 2 or the package of claim 3, wherein at least one metal layer is formed on a portion of the substrate prior to the formation of the material layer, said at least one metal layer being selected from for example nickel, gold, and palladium.

9. The method of claim 1, or 2 or the package of claim 3, wherein the substrate is a leadframe.

10. The integrated circuit package of claim 3 wherein the adhesive is formed either over the material layer; or over the adhesive.

*FIG.* 1

*FIG.* 2

VISCOSITY

HARDENING CURVE FOR AN EPOXY ADHESIVE HEATED AT A CONSTANT TEMPERATURE

50

GELPOINT
TIME

*FIG.* 3

$\gamma_L$

LIQUID
$\gamma_{LS}$

$\theta$

$\gamma_S$

*FIG. 4*

*FIG. 5*

**EP 0 954 025 A1**

## EUROPEAN SEARCH REPORT

European Patent Office

Application Number

EP 99 30 3045

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | EP 0 285 051 A (DU PONT) 5 October 1988 (1988-10-05) * claims 1,2 * | 1,3,6,9 | H01L23/495 H01L21/58 |
| A | WO 98 14997 A (TAY SWEE TECK ;QUANTUM MATERIALS INC (US)) 9 April 1998 (1998-04-09) * claims 1,7 * | 1,3,6,9 | |
| A | EP 0 780 435 A (NAT STARCH CHEM INVEST) 25 June 1997 (1997-06-25) | | |
| A | PATENT ABSTRACTS OF JAPAN vol. 018, no. 311 (E-1561), 14 June 1994 (1994-06-14) & JP 06 069257 A (HITACHI CHEM CO LTD), 11 March 1994 (1994-03-11) * abstract * | | |
| A | US 5 536 970 A (HIGASHI MICHIYA ET AL) 16 July 1996 (1996-07-16) | | TECHNICAL FIELDS SEARCHED (Int.Cl.6) H01L |

The present search report has been drawn up for all claims

| Place of search | Date of completion of the search | Examiner |
|---|---|---|
| THE HAGUE | 25 August 1999 | De Raeve, R |

EPO FORM 1503 03.82 (P04C01)

## ANNEX TO THE EUROPEAN SEARCH REPORT
## ON EUROPEAN PATENT APPLICATION NO.

EP 99 30 3045

This annex lists the patent family members relating to the patent documents cited in the above-mentioned European search report.
The members are as contained in the European Patent Office EDP file on
The European Patent Office is in no way liable for these particulars which are merely given for the purpose of information.

25-08-1999

| Patent document cited in search report | | Publication date | Patent family member(s) | | | Publication date |
|---|---|---|---|---|---|---|
| EP 0285051 | A | 05-10-1988 | CA | 1290676 | A | 15-10-1991 |
| | | | DE | 3881929 | A | 29-07-1993 |
| | | | DE | 3881929 | T | 02-12-1993 |
| | | | HK | 108393 | A | 22-10-1993 |
| | | | IL | 85892 | A | 30-05-1994 |
| | | | JP | 2515844 | B | 10-07-1996 |
| | | | JP | 63289822 | A | 28-11-1988 |
| | | | US | 5296074 | A | 22-03-1994 |
| | | | US | 4875279 | A | 24-10-1989 |
| WO 9814997 | A | 09-04-1998 | US | 5904500 | A | 18-05-1999 |
| | | | AU | 4809297 | A | 24-04-1998 |
| EP 0780435 | A | 25-06-1997 | CA | 2193707 | A | 22-06-1997 |
| | | | JP | 9183959 | A | 15-07-1997 |
| | | | US | 5807959 | A | 15-09-1998 |
| JP 06069257 | A | 11-03-1994 | NONE | | | |
| US 5536970 | A | 16-07-1996 | JP | 6236899 | A | 23-08-1994 |
| | | | KR | 9708355 | B | 23-05-1997 |

EPO FORM P0459

For more details about this annex : see Official Journal of the European Patent Office, No. 12/82